# EUROPEAN PATENT APPLICATION

(11) **EP 2 581 944 A1**
(43) Date of publication of application: **17.04.2013**
(21) Application number: 11795683.9
(22) Date of filing: 13.06.2011
(51) Int. Cl.: H01L 31/042, B32B 27/30

(54) **SOLAR CELL MODULE**

(30) Priority: 14.06.2010 JP 2010135196
(71) Applicant: Mitsubishi Chemical Corporation, Chiyoda-ku Tokyo 100-8251 (JP)
(72) Inventor: FUNAYAMA, Katsuya, Yokkaichi-shi Mie 510-8530 (JP); KASHIWAGI, Takuya, Yokkaichi-shi Mie 510-8530 (JP); YONEYAMA, Takahiro, Yokkaichi-shi Mie 510-8530 (JP)
(74) Representative: HOFFMANN EITLE
(86) International application number: PCT/JP2011/063473
(87) International publication number: WO 2011/158777

(57) **Abstract**

Disclosed is a solar cell module which uses polyvinyl chloride as the backing and does not undergo a decrease in adhesive strength between the backing and a sealing layer even when exposed to an outdoor environment. The solar cell module has a polyvinyl chloride backing, and a encapsulant-covered photoelectric conversion component and a weather-resistant layer that are laminated in this order on the backing. The module includes a first adhesive layer between the polyvinyl chloride backing and the encapsulant-covered photoelectric conversion component. The first adhesive layer is formed of a single layer, and contains a plurality of resins.

## Description

### TECHNICAL FIELD

The present invention relates to a solar cell module.

### BACKGROUND ART

In recent years, people's awareness of ecological issues is rising and expectations towards solar cells as a clean energy source are continuing to grow. In particular, the number of cases in which solar cells are installed on residential tile roofs or on the rooftops or walls of other types of buildings have increased from year to year. Nor are solar panels being installed only on the rooftops of homes; modules such as "roofing material-integrated solar cell modules" and "wall material-integrated solar cell modules" which are integral with the roof or walls of a building are being actively developed and installed. "Waterproof sheet-integrated solar cell modules" are attracting particular attention because such modules enable solar cells to be installed at the same time that waterproofing work is done on a building.

Waterproof sheets include synthetic rubber materials, olefin materials and polyvinyl chloride (PVC) materials. Of these, PVC materials are commonly used on account of their ease of installation, although the bleedout of plasticizer included in the PVC is a problem. Patent Document 1 discloses art which prevents plasticizer bleedout from PVC by introducing a plasticizer blocking layer. Use is made of, for example, ethylene-vinyl acetate (EVA) as the plasticizer blocking layer.

In building material-integrated solar cells, lamination with various building materials (backings) has been disclosed (see Patent Documents 2 and 3). For example, Patent Document 3, which addresses the problem of the durability of adhesion between a encapsulant covering a solar cell (also referred to below as the "photoelectric conversion component") and, in particular, a protective material on the back side, discloses the placement of an adhesion reinforcing layer containing either an acrylic resin or a silicone resin to which a silane coupling agent has been added between a encapsulant (EVA) and a back side protecting material (backing), such as a plastic material, steel plate, aluminum plate or stainless steel plate, so as to ensure the long-term durability of the adhesive properties.

### CITATION LIST

### Patent Literature

Patent Document 1: Japanese Unexamined Utility Model Application Laid-open No. H06-738
Patent Document 2: Japanese Patent Application Laid-open No. H08-135120
Patent Document 3: Japanese Patent Application Laid-open No. 2007-67248

### SUMMARY OF THE INVENTION

### Technical Problem

Patent Document 3 does not examine cases where PVC, which can be used as a waterproof sheet, served as the backing. Hence, the present inventors have investigated methods for preventing the migration of Plasticizers in PVC in cases where solar cells are laminated on PVC as the backing. As a result, the inventors have discovered that, even if the plasticizer blocking layer mentioned in Patent Document 1 is placed on PVC, when another resin layer such as a encapsulant is laminated on the blocking layer, the plasticizer contained in the PVC crosses the blocking layer and migrates into the resin layer that was laminated onto the blocking layer.
In other words, it has been found that, unlike the simple bleedout effects in PVC that have hitherto been reported, when the solar cell module is exposed to the outside environment, plasticizer migrates into the encapsulant that is made of a resin, leading to a marked decline in the adhesive strength between the backing and the encapsulant and to a decrease in plasticity owing to a drop in the plasticizer concentration of the backing itself, possibly compromising the performance as a waterproof sheet.
Moreover, because solar cell modules repeatedly expand and contract due to temperature fluctuations, precision designs which take into account thermal expansion coefficient differences among the constituent materials are carried out. In flexible solar cell modules in particular, encapsulants, for example, have the function of mitigating stress on a photoelectric conversion device incurred from other layers due to differences in thermal expansion coefficients between the photoelectric conversion device and other layers.
When the plasticizer included in PVC migrates to the encapsulant, the PVC hardens (the Young's modulus increases), as a result of which the stress generated by thermal expansion and contraction becomes larger. At the same time, the encapsulant softens (the Young's modulus decreases), as a result of which the function of mitigating stress on the adjoining solar cell declines, which in turn diminishes the photoelectric conversion device-protecting function. That is, it has been found that, during the long-term use of a solar cell module in which PVC is used as the backing, plasticizer migration proceeds and may lead to failure by the photoelectric conversion device.
The present invention resolves such problems.

### Means for solving the problem

The inventors, upon conducting extensive investigations in order to address the above problems, have found that, in a solar cell module which uses PVC as the backing and has a encapsulant-covered photoelectric conversion component and a weather-resistant layer that are laminated in this order on the backing, these problems can be solved by including, between the PVC backing and the encapsulant-covered photoelectric conversion component, a first adhesive layer which is formed of a single layer and contains a plurality of resins. This discovery ultimately led to the present invention. Accordingly, the present invention provides a solar cell module having a PVC backing, and a encapsulant-covered photoelectric conversion component and a weather-resistant layer that are laminated in this order on the backing. The module has a first adhesive layer between the PVC backing and the encapsulant-covered photoelectric conversion component, the first adhesive layer being formed of a single layer and containing a plurality of resins.

In a preferred embodiment, the first adhesive layer has a film thickness of 80 µm or less. In another preferred embodiment, the first adhesive layer includes at least one material selected from the group consisting of urethane resins, acrylic resins, methacrylic resins, epoxy resins and chloroprene rubbers.

In yet another preferred embodiment, the PVC backing is a plasticized PVC backing.

In a further preferred embodiment, the module includes a second adhesive layer between the first adhesive layer and the encapsulant-covered photoelectric conversion component. In a still further preferred embodiment, the second adhesive layer has a film thickness which is larger than the film thickness of the first adhesive layer.

In another preferred embodiment, the PVC backing contains a reinforcement. In still another preferred embodiment, the PVC backing has a peripheral region on which the encapsulant-covered photoelectric conversion component and the weather-resistant layer are not laminated, and the solar cell module is connectable to another solar cell module via the peripheral region.

According to another aspect, the present invention provides also a building material which includes the above-described solar cell module.

### Advantageous Effects of Invention

The present invention is able to provide a solar cell module which uses PVC as the backing. Even when exposed to an outdoor environment, the solar cell module does not undergo a decrease in adhesive strength between the backing and the encapsulant.
From the standpoint of ease of installation, plasticized PVC sheets in particular are commonly used as waterproof sheets in waterproofing work on buildings. However, solar cell modules which integrate a PVC sheet as a waterproof sheet together with solar cells and which are practically useful have not previously existed. By virtue of the present invention, solar cell modules which integrally unite a PVC sheet and solar cells and which are of practical use can now be provided.

### BRIEF DESCRIPTION OF THE DRAWINGS

FIG. 1 is a schematic view of a first embodiment of the solar cell module of the present invention.
FIG. 2 is a schematic view of a second embodiment of the solar cell module of the present invention.
FIG. 3 is a schematic view of a third embodiment of the solar cell module of the present invention.

### DESCRIPTION OF THE EMBODIMENTS

The solar cell module of the present invention is a solar cell module having a PVC backing, and a encapsulant-covered photoelectric conversion component and a weather-resistant layer that are laminated in this order on the backing. The module has a first adhesive layer between the PVC backing and the encapsulant-covered photoelectric conversion component. The first adhesive layer is formed of a single layer and contains a plurality of resins.
The first adhesive layer, which is a distinctive feature of the present invention, is described first below.

### First Adhesive Layer

The solar cell module of the present invention uses a PVC backing, and is characterized by having a first adhesive layer between the PVC backing and the encapsulant-covered photoelectric conversion component.
The PVC backing has an excellent durability and ease of installation as a waterproof sheet, but it contains a lot of plasticizer.
The inventors have found that when PVC is used as the backing in a solar cell module, a problem particular to solar cell modules arises on account of the plasticizer included in the PVC. That is, the inventors have discovered that in cases where PVC is used as the backing in solar cell modules, even when a plasticizer blocking layer is provided, plasticizer migrates to the resin layer adjacent to the blocking layer, and that such migration is accompanied both by a marked decrease in adhesion between the PVC backing and the resin layer and by a decline in the plasticity of the PVC backing itself. At the same time, the change in the plasticizer concentration within the PVC backing due to plasticizer migration from the PVC backing is accompanied by a change in the thermal expansion coefficient of the PVC backing, changing the stress that acts upon the photoelectric conversion component and creating a risk of failure by the photoelectric conversion device. These problems were solved by providing an adhesive layer which contains a plurality of resins, ultimately leading to the present invention.

The first adhesive layer in this invention is formed of a single layer and contains a plurality of resins.
When using PVC as the backing in solar cells, owing to a variety of reasons, such as the cost of the manufactured article and the difficulty of adjusting the adhesive layer, an adhesive layer composed of only one type of resin has hitherto been used. However, in cases where the adhesive layer is composed of only one type of resin, a trade-off exists between the migration of plasticizer within the PVC and the adhesive properties between the PVC and the photoelectric conversion component. As a result, it has been found to be difficult to maintain, within a harsh environment such as the outdoors, the high adhesion that exists at first following production.
By contrast, when a plurality of resins are mixed together, the adhesive layer has a plurality of differing glass-transition temperatures (Tg) and thus absorbs the strains associated with the thermal expansion and contraction of the respective materials that occurs due to temperature changes in an outdoor environment, enabling adherence at the adjoining interfaces to be maintained at a high level.

The resins included in the first adhesive layer are not particularly limited, and are exemplified by acrylic resins, methacrylic resins, urethane resins, α-olefin resins, vinyl acetate resins, chloroprene rubbers, epoxy resins, nitrile rubbers and silicon resins.
As used herein, "acrylic resins" refers to acrylic monomer-based polymers and copolymers, "methacrylic resins" refers to methacrylic monomer-based polymers and copolymers, "urethane resins" refers to urethane resin-based polymers and copolymers, "α-olefin resins" refers to α-olefin monomer-based polymers and copolymers, and "vinyl acetate resins" refers to vinyl acetate monomer-based polymers and copolymers.

The first adhesive layer of the present invention preferably includes at least one type of resin having the ability to adhere to the PVC backing, and is more preferably composed of two or more resins having the ability to adhere to the PVC backing. In this way, even if plasticizer migrates to the first adhesive layer, the plasticizer becomes present in one of the resin phases included within the first adhesive layer (a resin phase having a higher affinity to the plasticizer) but the adhesive function of the first adhesive layer overall is not impaired.

Resins having a high adhesion with the PVC backing include acrylic resins, methacrylic resins, urethane resins, α-olefin resins, vinyl acetate resins, chloroprene rubbers and epoxy resins. From the standpoint of the adhesive properties and thermal durability, acrylic resins, methacrylic resins and urethane resins are preferred.
Acrylic resins known as adhesives, such as alkyl (meth)acrylate homopolymers (e.g., methyl (meth)acrylate, ethyl (meth)acrylate, butyl (meth)acrylate), and copolymers thereof with copolymerizable monomers, may be used as the acrylic resins and methacrylic resins. The urethane resins are not subject to any particular limitation, provided they are resins having urethane linkages. Urethane resins that may be used include urethane resins which are known as adhesives and are obtained by reacting an isocyanate compound, a polyhydroxy compound and, if necessary, a diamine compound or an amino alcohol.
Examples of resins having a high ability to prevent plasticizer migration include acrylic resins, methacrylic resins, α-olefin resins and nitrile rubbers. From the standpoint of adhesion and heat durability, acrylic resins and methacrylic resins are preferred.
Including at least one resin having a high adhesive ability and at least one resin having a high ability to prevent plasticizer migration is preferred.
From the standpoint of thermal durability and the adhesive properties at interfaces between different resins, it is preferable for at least one of the plurality of resins to be a copolymer. A copolymer of any material from among acrylic resins, urethane resins, α-olefin resins, chloroprene rubbers and methacrylic resins is preferred; and a copolymer of any material from among acrylic resins, methacrylic resins and urethane resins is more preferred. When the resin is a copolymer, this is desirable also in that properties such as the compatibility between the plurality of resins, and adhesion with the layers above and below the first adhesive layer can be adjusted.

The resins included in the first adhesive layer of the present invention preferably have a glass-transition temperature (Tg). The resin Tg is generally 150°C or below, more preferably 130°C or below, and even more preferably 120°C or below. The Tg is preferably at least 10°C, more preferably at least 20°C, and even more preferably at least 30°C. It is more preferable for the Tg of at least 50 wt% of the resins included in the first adhesive layer to be within the above temperature range, and even more preferable for the Tg of all the resin included in the first adhesive layer to be within the above temperature range.
By setting the difference between the Tg of the plasticizer-containing PVC backing and the Tg of the first adhesive layer within a fixed range, thermal expansion differences in the temperature region of the service environment become smaller, as a result of which interfacial adhesion is not compromised, enabling the adhesive strength immediately after lamination of the encapsulant with the PVC backing to be maintained even in the service environment.
At the same time, regions of low adhesion do not readily form, and so migration of the plasticizer included within the PVC backing into locally low-adhesion regions which may arise at the interface between the PVC backing and the first adhesive layer can be suppressed.
Because plasticizer readily migrates into regions having a low interfacial adhesion, once a region having a low adhesion arises at the interface, the migration of plasticizer into that region proceeds. As a result, interfacial adhesion decreases further, so that plasticizer migration continues to proceed. Moreover, due to the rise in the concentration of plasticizer that has migrated to regions having a low interfacial adhesion, plasticizer more readily migrates to the encapsulant adjacent to the adhesive layer, thus lowering also the interfacial adhesion at other layers adjoining the encapsulant.

The film thickness of the first adhesive layer is typically at least 0.5 µm, preferably at least 1 µm, more preferably at least 3 µm, and even more preferably at least 5 µm. By setting the lower limit in the film thickness within the above-indicated range, the first adhesive layer fully absorbs stresses applied to the PVC backing from the exterior, making it difficult for such stress to be transmitted to the encapsulant and the photoelectric conversion component. As a result, the photoelectric conversion component is protected from stresses that act on the PVC backing. The upper limit in the film thickness of the first adhesive layer is typically 100 µm or less, preferably 80 µm or less, more preferably 50 µM or less, and even more preferably 10 µm or less. By setting the upper limit in the film thickness within the above-indicated range, migration of the plasticizer from the PVC backing to the first adhesive layer is suppressed, making it easier to maintain the adhesive strength at the interface between the PVC backing and the first adhesive layer.
Moreover, when the film thickness is in the above range, undesirable effects due to linear expansion differences between the PVC backing and the first adhesive layer do not readily arise. Also, when coating the first adhesive layer onto the PVC backing, a good smoothness can be achieved and a decline in adhesion does not occur.

### Second Adhesive Layer

It is preferable for the solar cell module of the present invention to additionally have a second adhesive layer between the first adhesive layer and the encapsulant-covered photoelectric conversion component. There are cases in which much plasticizer is included in the PVC backing, and a substantial amount of plasticizer migrates from the PVC backing to the first adhesive layer. At such a time, a substantial amount of plasticizer migrates also from the first adhesive layer to the encapsulant. The plasticizer which has migrated accumulates at the interface between the photoelectric conversion component and the encapsulant having a relatively low adhesion, and the accumulated plasticizer adsorbs moisture from within the encapsulant, sometimes adversely affecting not only on the adhesion but also the electrical properties. Hence, by providing a second adhesive layer between the first adhesive layer and the encapsulant-covered photoelectric conversion component, plasticizer migration to the encapsulant can be completely prevented, which is desirable.

The material making up the second adhesive layer may be used without particular limitation, provided it is able to prevent plasticizer migration. Exemplary materials include polyester resins, acrylic resins, aromatic polycarbonate resins, polyolefin resins, styrene resins, epoxy resins, polyethersulfone resins, polyetherimide resins and fluoroplastics.
Of these, from the standpoint of preventing plasticizer migration and the adhesive properties with the encapsulant, polyester resins, acrylic resins and fluoroplastics are preferred, with polyester resins and fluoroplastics being more preferred.
Illustrative examples of fluoroplastics include polytetrafluoroethylene (PTFE), 4-fluoroethylene-perchloroalkoxy copolymers (PFA), 4-fluoroethylene-6-fluoropropylene copolymers (FEP), 2-ethylene-4-fluoroethylene copolymers (ETFE), poly(3-fluorochloroethylene) (PCTFE), polyvinylidene fluoride (PVDF) and polyvinyl fluoride (PVF).

To improve adhesion and other properties, the second adhesive layer may be subjected, on one or both sides thereof, to surface treatment such as corona treatment, plasma treatment, ozone treatment, UV irradiation, electron beam irradiation or flame treatment.

In cases where the solar cell module of the present invention has a second adhesive layer, it is preferable for the second adhesive layer to have a film thickness which is larger than the film thickness of the first adhesive layer. Specifically, the thickness ratio between the first adhesive layer and the second adhesive layer (first adhesive layer/second adhesive layer) is preferably at least 0.003, more preferably at least 0.01, and even more preferably at least 0.05. On the other hand, the thickness ratio is preferably less than 1, more preferably 0.5 or less, and even more preferably 0.1 or less. By having the ratio (first adhesive layer/second adhesive layer) fall in the above range, the adhesive strength at the first adhesive layer/second adhesive layer interface increases, making it easier for the adhesive layers to conform to bending of the backing and thus discouraging peeling. The above range is also preferable from the standpoint of coatability.

The second adhesive layer has a film thickness of preferably at least 30 µm, more preferably at least 50 µm, and even more preferably at least 80 µm. The upper limit is preferably not more than 300 µm, more preferably not more than 200 µm, and most preferably not more than 100 µm. At a second adhesive layer film thickness in the above range, stress and strain do not arise between the first adhesive layer and the second adhesive layer, adhesion is good, and plasticizer migration can be effectively suppressed, making it possible to ensure sufficient flexibility of the PVC backing.

### PVC Backing

The PVC backing used in the solar cell module of the present invention is utilized as a waterproof sheet, but is also a backing which is easy to install and has a high practical utility. The present invention resolves the challenges that arise during the production of solar cell modules which use a PVC backing, and has a very high utility as a building material.
In this invention, the PVC backing is not subject to any particular limitation; use may be made of a PVC backing which is commercially available. Generally, a plasticizer is added to the PVC backing in order to enhance the flexibility and make the backing easier to work. Plasticized PVC backings which have a particularly good workability contain a lot of plasticizer. When such PVC backings which contain a lot of plasticizer are used in solar cell modules, the plasticizer ends up migrating to adjoining layers, giving rise to a marked decline in the adhesive strength, but such a problem has been resolved by this invention.

The amount of plasticizer included in the PVC backing of the present invention is generally at least 20 wt%, preferably at least 30 wt%, more preferably at least 40 wt%, and even more preferably at least 45 wt%. By setting the amount of plasticizer in the above range, it is possible to achieve a good flexibility and ease of installation. The upper limit value is typically 80 wt% or less, preferably 75 wt% or less, more preferably 65 wt% or less, and more preferably 60 wt% or less. By setting the amount of plasticizer in the above range, plasticizer migration to other layers can be more effectively prevented.
In particular, to effectively manifest flexibility in the solar cell module, a plasticized PVC backing having a plasticizer content of 40 to 75% is preferred.

The PVC backing of the present invention has a thickness which is typically at least 0.5 mm, preferably at least 1 mm, more preferably at least 1.5 mm, and more preferably at least 2 mm. The upper limit is typically 10 mm or less, preferably 4 mm or less, more preferably 3 mm or less, and most preferably 2.5 mm or less. At a PVC backing thickness in the above range, the solar cell module has a good mechanical strength and a suitable ease of installation.
The PVC backing may be formed of a plurality of layers.
By producing the solar cell module of the present invention by bonding to a commercially available waterproof sheet made of PVC, the efficiency of installation can be increased. In this case, although there is no particular limitation on the thickness of the PVC backing, a small thickness is preferable for lowering the weight of the waterproof sheet to which the solar cell module of the present invention has been bonded.
That is, the thickness is typically at least 0.1 mm, preferably at least 0.5 mm, and more preferably at least 1 mm.
The upper limit is typically 3 mm or less, preferably 2.5 mm or less, more preferably 2 mm or less, and even more preferably 1.5 mm or less.
The sum of the thickness of the commercial PVC waterproof sheet and the thickness of the PVC backing in the solar cell module of the present invention is typically 10 mm or less, preferably 5 mm or less, and more preferably 4 mm or less.

The ratio of the thickness of the subsequently described encapsulant-covered photoelectric conversion component to the thickness of the PVC backing (photoelectric conversion component thickness/PVC backing thickness) is not particularly limited, although a ratio of from 0.13 to 1.0 is preferred from the standpoint of ease of installation, mechanical strength and protection of the photoelectric conversion component.

The plasticizer included in the PVC backing of the present invention is exemplified by phthalic acid ester-type materials, polyester-type materials, fatty acid ester-type materials, epoxy-type materials and phosphoric acid ester-type materials. Of these, from the standpoint of affinity with PVC, phthalic acid ester-type materials and polyester-type materials are preferred. From the standpoint of the ease of installation when using the solar cell module of the present invention as a building material or the like, a phthalic acid ester-type material having a high plasticizer effect is more preferred.
Examples of phthalic acid ester-type materials include, but are not particularly limited to, dibutyl phthalate, diisobutyl phthalate, di-n-hexyl phthalate, di-2-ethylhexyl phthalate and diisononyl phthalate.
Examples of polyester-type materials include, but are not particularly limited to, adipic acid-type polyesters, sebacic acid-type polyesters and phthalic acid-type polyesters.

Examples of fatty acid ester-type materials include, but are not particularly limited to, tri-n-butyl citrate, dioctyl adipate, dioctyl sebacate and dioctyl azelate.
Examples of epoxy-type materials include, but are not particularly limited to, alkyl epoxy stearate and isodecyl 4,5-epoxytetrahydrophthalate.
Examples of phosphoric acid ester-type materials include, but are not particularly limited to, tricresyl phosphate and trioctyl phosphate.

The plasticizer has a weight-average molecular weight (Mw) which, although not particularly limited, is typically at least 250, preferably at least 300, and more preferably at least 400. The upper limit is typically 4,000 or less, preferably 2,500 or less, and more preferably 1,000 or less. A plasticizer having an average molecular weight in the above range is able to confer the PVC backing with a suitable durability and resistance to moist heat. The average molecular weight (Mw) can be measured by size exclusion chromatography (SEC).

In cases where the solar cell module of the present invention is used as a building material, it is essential for the PVC backing to be flame-retarding.
Any known method for conferring the PVC backing with flame retardance may be used, although the method of including a flame retardant is preferred. Exemplary flame retardants include halogen compounds such as brominated compounds, phosphorus-containing compounds, hindered amine compounds, alumina trihydrates such as aluminum hydroxide, boron compounds such as calcium borate, antimony compounds, and magnesium hydroxide.

The PVC backing preferably includes a reinforcement. By including a reinforcement, it is possible to increase the mechanical strength, suppress shape distortion due to wind pressure, and mitigate shrinkage due to outdoor exposure. Also, including a reinforcement enables thermal expansion of the PVC backing to be suppressed. Preferred examples of reinforcements include fibrous reinforcements such as glass fibers, vinylon fibers, aramid fibers, carbon fibers, nylon fibers, polyester fibers and acrylic fibers. Of these, glass fibers, carbon fibers and polyester fibers, all of which have substantially no influence on solar cells, are preferred. From the standpoint of the thermal expansion-suppressing effects of PVC backings, glass fibers are more preferred. These reinforcements may be included in the PVC backing, or the PVC backing may be laminated together with reinforcement that has been formed into a woven fabric or a nonwoven fabric.
Of these, it is preferable to laminate the PVC backing together with a reinforcement that has been formed into a woven fabric. Particularly in cases where the solar cell module of the present invention is to be used as a roof material, from the standpoint of resistance to wind pressure, laminating glass fibers that have been formed into a woven fabric is preferred. With regard to the order in which the PVC backing and the reinforcement are laminated, the reinforcement may be laminated on the encapsulant side of the PVC backing, on the side opposite to the encapsulant, or between a plurality of PVC backings. From the standpoint of reducing damage to the solar cell due to deformation of the PVC backing, it is preferable to laminate the reinforcement within the PVC backing on the encapsulant side.

The PVC backing preferably has a peripheral region on which the encapsulant-covered photoelectric conversion component is not laminated. That is, it is preferable for the PVC backing in the solar cell module to have a surface area which is larger than the surface area of the light-receiving surface and for the solar cell module to have a peripheral region which is composed of only the PVC backing. It is more preferable for the light-receiving surface of the solar cell module to be mounted at the center of the PVC backing.
By having such a peripheral region, interconnection with other solar cell modules via the peripheral region is easy. Examples of the method of interconnection include, without particular limitation, methods that involve the formation of holes and fastening together the modules using fasteners, methods that involve sewing the modules together, methods that involve bonding with the use of adhesives, and methods that involve thermal bonding. Any such method may be selected in accordance with the intended purpose.
In particular, a method in which the peripheral regions of the PVC backings are thermally bonded together is preferred because a large surface area waterproof sheet can easily be obtained.
In the solar cell module, the ratio of the surface area of the peripheral region where the PVC backing is exposed to the surface area of the overall solar cell module (surface area of peripheral region/surface area of overall solar cell module) is typically at least 2%, preferably at least 5%, and more preferably at least 10%. This ratio is typically 60% or less, preferably 45% or less, and more preferably 30% or less.
By setting the ratio within such a range, a good amount of power is generated per surface area, in addition to which the work of coupling together the solar cell modules of the present invention during installation can easily be carried out.

### Photoelectric Conversion Component

The photoelectric conversion component of the present invention is covered with the subsequently described encapsulant, and is formed of a photoelectric conversion device which converts sunlight into electricity and a photoelectric conversion device base material for suppressing changes in the shape of the photoelectric conversion device. In addition, where necessary, a gas barrier layer, a wavelength conversion layer and a UV absorption layer may also be laminated. As used above, "covered" signifies that at least part of the photoelectric conversion component is covered, and does not necessarily refer to complete coverage. Also, the encapsulant may cover either the light-receiving surface of the photoelectric conversion component or the reverse side, or may cover both sides, although having the encapsulant cover both sides is preferable from the standpoint of impact resistance. In addition, covering both sides is preferable from the standpoint of the voltage resistance as well, although this depends also on the manner of installation.

### Photoelectric Conversion Device

The photoelectric conversion device is an element which carries out photoelectric conversion based on sunlight incident on the subsequently described weather-resistant layer side thereof. This photoelectric conversion device is not particularly limited, provided it can convert light energy into electrical energy and is capable of extracting electrical energy obtained by such conversion to the exterior.

The photoelectric conversion device used may be formed of a photoelectric conversion layer (photoelectric conversion layer, light absorption layer) sandwiched between a pair of electrodes, may be formed of a laminate of a photoelectric conversion layer and another layer (e.g., a buffer layer) sandwiched between a pair of electrodes, or may be formed of a serially connected array of a plurality of such elements.
Various materials may be used as the photoelectric conversion layer, although a layer composed of thin-film monocrystalline silicon, thin-film polycrystalline silicon, amorphous silicon, microcrystalline silicon, spherical silicon, inorganic semiconductor materials, organic dye materials, or organic semiconductor materials is preferred. Using these materials enables a thin (lightweight) photoelectric conversion device having a relatively high power-generating efficiency to be achieved.
Although using a PVC backing enables flexibility to be achieved, for the solar cell module to have flexibility, amorphous silicon, microcrystalline silicon, spherical silicon, an inorganic semiconductor material, an organic dye material or an organic semiconductor material is preferred. Of these, amorphous silicon is especially preferred.
From the standpoint of increasing efficiency, these may be used in a tandem cell stack or triple cell stack.

When the photoelectric conversion layer is composed of thin-film polycrystalline silicon, the photoelectric conversion device is an element of a type which utilizes indirect optical transitions. Therefore, when the photoelectric conversion layer is made a thin-film polycrystalline silicon layer, to increase light absorption, it is preferable to provide a sufficiently optically closed structure by, for example, forming a textured structure on the subsequently described photoelectric conversion device base material or on the surface thereof.

In cases where the photoelectric conversion layer is composed of amorphous silicon, a solar cell can be achieved which has a large optical absorption coefficient in the visible wavelength region and is fully capable of absorbing sunlight even with a thin-film having a thickness of about 1 µm. Moreover, because amorphous silicon is a non-crystalline material, it also has resistance to deformation. Hence, when an amorphous silicon layer is used as the photoelectric conversion layer, it is possible to achieve a solar cell module which is particularly lightweight and also has a certain degree of resistance to deformation. On the other hand, because the wavelength region in which power can be generated is narrow, creating a broader wavelength region by adopting a tandem cell or triple cell structure is preferred.

In cases where the photoelectric conversion layer is composed of an inorganic semiconductor material (compound semiconductor), solar cells having a high power-generating efficiency can be achieved. From the standpoint of the power-generating efficiency (photoelectric conversion efficiency), the photoelectric conversion layer is preferably a chalcogenide photoelectric conversion layer containing chalcogen elements such as sulfur, selenium and tellurium, and more preferably a Group I-III-VI₂ semiconductor-type (chalcopyrite-type) photoelectric conversion layer. A Cu-III-VI₂ group semiconductor-type photoelectric conversion layer in which copper is used as the group I element, and especially a CIS-type semiconductor (CuIn (Se_{1-y}S_{y})₂, where 0 ≤ y ≤ 1) layer or a CIGS-type semiconductor (Cu (In₁₋ₓGaₓ) (Se_{1-y}S_{y}), where 0 < x < 1 and 0 y ≤ 1) layer, is preferred.

In cases where the photoelectric conversion layer is a dye-sensitized photoelectric conversion layer formed of, for example, a titanium oxide layer and an electrolyte layer, a photoelectric conversion device having a high power-generating efficiency can be achieved.
In cases where the photoelectric conversion layer is an organic semiconductor layer (a layer containing a p-type semiconductor and an n-type semiconductor), this is advantageous in that the photoelectric conversion layer can be formed by coating.
Illustrative examples of p-type semiconductors which may be used in the organic semiconductor layer include porphyrin compounds such as tetrabenzoporphyrin, copper tetrabenzoporphyrin and zinc tetrabenzoporphyrin; phthalocyanine compounds such as phthalocyanine, copper phthalocyanine and zinc phthalocyanine; polyacenes such as tetracene and pentacene; oligothiophenes such as sexithiophene; and derivatives containing these compounds as the skeleton. Additional examples of p-type semiconductors which may be used in the organic semiconductor layer include the following polymers: polythiophenes such as poly(3-alkylthiophenes), polyfluorenone, polyphenylene vinylene, polytriallylamine, polyacetylene, polyaniline and polypyrrole.

Polymeric organic semiconductor materials that may be advantageously used include π-conjugated polymeric materials and π-conjugated low-molecular-weight organic compounds. Use may be made of a single compound or a mixture of a plurality of compounds. The conjugated polymeric material may be a material obtained by polymerizing a single π-conjugated monomer or a plurality of π-conjugated monomers. Examples of such monomers include thiophene, fluorenone, carbazole, diphenylthiophene, dithienothiophene, dithienosilole, dithienocyclohexane, benzothiadiazole, thienothiophene, imidothiophene, benzodithiophene and phenylene-vinylene, and of which may have substituents. These monomers may be directly bonded or may be bonded through CH=CH, C=C, a nitrogen atom or an oxygen atom. Use may also be made of polymers such as polytriallylamine and polyacetylene. The polymer-containing semiconductor material has a molecular weight of preferably at least 10,000.
Examples of low-molecular-weight organic semiconductor materials include condensed aromatic hydrocarbons containing a polyacene such as pentacene or naphthacene, oligothiophenes containing at least four thiophene rings, porphyrin compounds and tetrabenzoporphyrin compounds as well as metal complexes thereof, phthalocyanine compounds and metal complexes thereof, and derivatives containing these compounds as the skeleton.
The metals in the metal complex are preferably copper and zinc.

Examples of n-type semiconductors which may be used in the organic semiconductor layer include, but are not particularly limited to, fullerenes (e.g., C₆₀, C₇₀ or C₇₆), fullerenes having substituents on two carbons, fullerenes having substituents on four carbons, and fullerenes having substituents on six carbons; octaazaporphyrin; perfluorinated forms of the above-mentioned p-type semiconductors; aromatic carboxylic anhydrides and imide compounds thereof, such as naphthalene tetracarboxylic anhydride, naphthalene tetracarboxylic diimide, perylene tetracarboxylic anhydride and perylene tetracarboxylic diimide; and derivatives containing these compounds as the skeleton.

Specific examples of the organic semiconductor layer structure include a bulk heterojunction structure having a layer (i layer) with the p-type semiconductor and the n-type semiconductor phase-separated within the layer, a stacked structure (hetero pn junction-type) in which a p-type semiconductor-containing layer (p layer) and an n-type semiconductor-containing layer (n layer) are stacked, a PIN structure, a Schottky structure, and combinations of these.

The respective electrodes of the photoelectric conversion device may be formed using any one, two or more materials having electrical conductivity. Illustrative examples of electrode materials (the materials making up the electrodes) include metals such as platinum, gold, silver, aluminum, chromium, nickel, copper, titanium, magnesium, calcium, barium and sodium, as well as alloys of these; metal oxides such as indium oxide and tin oxide, and also alloys thereof (ITO: indium tin oxide); conductive polymers such as polyaniline, polypyrrole, polythiophene and polyacetylene; materials obtained by including in such conductive polymers a dopant, examples of which include acids such as hydrochloric acid, sulfuric acid and sulfonic acid, Lewis acids such as FeCl₃, halogen atoms such as iodine, and metal atoms such as sodium and potassium; and conductive composite materials obtained by dispersing conductive particles such as metal particles, carbon black, fullerene or carbon nanotubes in a matrix such as a polymer binder.

The electrode material is preferably a material suitable for trapping holes or electrons. Examples of electrode materials suitable for trapping holes (i.e., materials having a high work function) include gold and ITO. Examples of electrode materials suitable for trapping electrons (i.e., materials having a low work function) include silver and aluminum.

The respective electrodes of the photoelectric conversion device may have substantially the same size as the photoelectric conversion layer, or may be smaller than the photoelectric conversion layer. However, in cases where the electrode on the light-receiving side (weather-resistant layer side) of the photoelectric conversion device is made relatively large (the surface area is not sufficiently small relative to the surface area of the photoelectric conversion layer), that electrode should be made a transparent (light-transmitting) electrode, and in particular an electrode having a relatively high (e.g., 50% or higher) transmittance to light of a wavelength that the photoelectric conversion layer can efficiently convert to electrical energy. Examples of transparent electrode materials include oxides such as ITO and IZO (indium oxide-zinc oxide) and metal thin-films.

The thicknesses of the respective electrodes and the thickness of the photoelectric conversion layer in the photoelectric conversion device may be set based on such considerations as the required power output.
In addition, an auxiliary electrode may be provided in such a way as to come into contact with the electrodes. This is particularly effective in cases where an electrode having a somewhat low conductivity, such as ITO, is used. The same materials as the metal materials mentioned above may be used as the auxiliary electrode materials, provided they have a good conductivity. Illustrative examples include silver, aluminum and copper.

### Photoelectric Conversion Device Base Material

The photoelectric conversion device base material is a member on one side of which the photoelectric conversion device is formed. It is thus desired that the photoelectric conversion device base material have a relatively high mechanical strength, excellent weather resistance, heat resistance and chemical resistance, and also a light weight. It is also desired that the photoelectric conversion device base material have some degree of resistance to deformation. Hence, it is preferable to use a metal foil, a resin film having a melting point of 85 to 350°C, or a laminate of several metal foils/resin films as the photoelectric conversion device base material.

Examples of metal foils which may be used as the photoelectric conversion device base material (or a constituent component thereof) include foils composed of aluminum, stainless steel, gold, silver, copper, titanium, nickel, iron, and alloys thereof. Resin films having a melting point of from 85 to 350°C include films made of, for example, polyethylene, polypropylene, polystyrene, polyvinyl chloride, polyethylene terephthalate, polyethylene naphthalate, polybutylene terephthalate, polycarbonates, polyacetal, acrylic resins, polyamide resins, ABS resins, ACS resins, AES resins, ASA resins and copolymers of these, fluoroplastics such as PVDF and PVF, silicone resins, cellulosic resins, nitrile resins, phenolic resins, polyurethanes, ionomers, polybutadiene, polybutylene, polymethylpentene, polyvinyl alcohol, polyarylate, polyetheretherketone, polyetherketone and polyethersulfone.
Resin films used as the photoelectric conversion device base material may be films obtained by dispersing glass fibers, organic fibers, carbon fibers or the like in resins such as the above.

It is desirable for the resin film used as the photoelectric conversion device base material (or a constituent component thereof) to have a melting point in the range of 85 to 350°C because deformation of the photoelectric conversion device base material does not occur and delamination with the photoelectric conversion device does not arise. The melting point of the resin film used as the photoelectric conversion device base material (or a constituent component thereof) is more preferably at least 100°C, even more preferably at least 120°C, still more preferably at least 150°C, and most preferably at least 180°C. Also, the melting point of the resin film is more preferably 300°C or less, more preferably 280°C or less, and even more preferably 250°C or less.

It has been found from various experimental results that in cases where a material which is thinner than the subsequently described encapsulant is used as the photoelectric conversion device base material, cracks readily arise in the encapsulant when the solar cell module is bent. Hence, a material which is thinner than the encapsulant should be used as the photoelectric conversion device base material, the use of a material having a thickness which is not more than 0.83 (=1/1.2) times the thickness of the encapsulant being preferred, the use of a material having a thickness which is not more than 0.67 (=1/1.5) times the thickness of the encapsulant being more preferred, and the use of a material having a thickness which is not more than 0.5 times the thickness of the encapsulant being especially preferred.

### Encapsulant

The encapsulant is provided in the solar cell module for such purposes as to seal the photoelectric conversion device. Illustrative examples of materials that may be used as the encapsulant include resin materials having comparatively-high solar transmittance, for example, polyolefin resins such as polyethylene, polypropylene, ethylene-vinyl acetate copolymers (EVA), ethylene-methyl acrylate copolymers, ethylene-ethyl acrylate copolymers, propylene-ethylene-α-olefin copolymers, and also butyral resins, styrene resins, epoxy resins, (meth)acrylic resins, urethane resins, silicon resins and synthetic rubbers. These may be used as mixtures or as copolymers of one or more thereof.
Of the above, ethylene-vinyl acetate copolymers (EVA) and urethane resins are preferred owing to their high adhesive strength, and polyolefin resins such as propylene-ethylene-α-olefin copolymers are preferred from the standpoint of resistance to hydrolysis.

The encapsulant has a thickness of preferably at least 100 µm, more preferably at least 200 µm, and even more preferably at least 300 µm. On the other hand, the thickness is preferably 1,000 µm or less, more preferably 800 µm or less, and even more preferably 500 µm or less. Setting the encapsulant thickness in the above range enables a suitable impact resistance to be obtained. A encapsulant thickness in this range is desirable also from the standpoint of cost and weight, and moreover enables the power-generating properties to be fully exhibited.

### Weather-Resistant Layer

The weather-resistant layer is a layer for conferring the solar cell module with such properties as mechanical strength, weather resistance, scratch resistance, chemical resistance, and gas barrier properties. The weather-resistant layer is preferably a layer which does not hinder light absorption by the photoelectric conversion device; that is, a layer which transmits light of wavelengths that the photoelectric conversion layer can efficiently convert to electrical energy. For example, the layer has a solar transmittance of preferably at least 80%, and more preferably at least 85%.

Moreover, because the solar cell module is heated by sunlight, the weather-resistant layer preferably has heat resistance. The material making up the weather-resistant layer has a melting point of preferably at least 100°C, and more preferably at least 120°C. The melting point has an upper limit of preferably 320°C or less.

The material making up the weather-resistant layer may be selected while taking these properties into consideration. For example, polyethylene resins, polypropylene resins, cyclic polyolefin resins, acrylonitrile-styrene (AS) resins, acrylonitrile-butadiene-styrene (ABS) resins, polyvinyl chloride resins, fluoroplastics, polyester resins such as polyethylene terephthalate and polyethylene naphthalate, phenolic resins, polyacrylic resins, (hydrogenated) epoxy resins, polyamide resins such as various types of nylons, polyimide resins, polyamide-imide resins, polyurethane resins, cellulosic resins, silicon resins and polycarbonate resins may be used as the material making up the weather-resistant layer. Of these, from the standpoint of weather resistance, preferred use may be made of fluoroplastics such as copolymers of tetrafluoroethylene and ethylene (ETFE).
The weather resistant layer may be composed of two or more different materials. Also, the weather-resistant layer may be a single layer or a laminate of two or more layers. In addition, where necessary, the lamination plane may be subjected to surface treatment such as corona discharge treatment, plasma treatment, ozone treatment, UV irradiation, electron beam irradiation or flame treatment.

Although the thickness of the weather-resistant layer is not particularly specified here, making the thickness larger tends to increase the mechanical strength, and making it smaller tends to increase the flexibility. Hence, the thickness of the weather-resistant layer is typically at least 10 µm, preferably at least 15 µm, and more preferably at least 20 µm, but is typically not more than 200 µm, preferably not more than 180 µm, and more preferably not more than 150 µm.
In summary, depending on the intended purpose, layers of various thicknesses which are composed of a material having weather resistance, heat resistance and the like may be used as the weather-resistant layer.

### Method of Manufacturing the Solar Cell Module

In the solar cell module of the present invention, the weather-resistant layer, the encapsulant-covered photoelectric conversion component (encapsulant, photoelectric conversion device, photoelectric conversion device base material), a first adhesive layer and PVC backing are laminated in this order, and preferably a second adhesive layer is placed between the encapsulant-covered photoelectric conversion component and the first adhesive layer. Commonly used methods may be employed to laminated the respective layers. For example, an adhesive, a hot-melt agent, a UV-curable resin or a heat-curable resin may be used. From the standpoint of productivity and long-term durability, it is preferable to laminate the respective constituent layers by hot lamination (vacuum lamination).

The procedure for integrally building the solar cell module is exemplified by a method wherein a laminate which includes a weather-resistant layer and a encapsulant-covered photoelectric conversion component (photoelectric conversion device, photoelectric conversion device base material), and preferably a second adhesive layer, is beforehand laminated separately with the first adhesive layer and the PVC backing, following which both are hot laminated together. An alternative method is to first place the first adhesive layer on the second adhesive layer, then to hot laminate the weather-resistant layer, the encapsulant-covered photoelectric conversion component (photoelectric conversion device, photoelectric conversion device base material) and the PVC backing. Any of the respective layers may be subjected to surface treatment such as corona discharge treatment, plasma treatment, ozone treatment, UV irradiation, electron beam irradiation or flame treatment.

The hot lamination conditions are not particularly limited; hot lamination under the conditions normally carried out is possible. Hot lamination is preferably carried out under vacuum conditions, the degree of vacuum being typically at least 30 Pa, preferably at least 50 Pa, and more preferably at least 80 Pa. The upper limit is typically not more than 150 Pa, preferably not more than 120 Pa, and more preferably not more than 100 Pa. Setting the degree of vacuum in the above range makes it possible to suppress the generation of air bubbles in the respective layers within the module, and is also preferable for enhancing productivity.
The vacuum time is typically at least 1 minute, preferably at least 2 minutes, and more preferably at least 3 minutes. The upper limit is typically not more than 8 minutes, preferably not more than 6 minutes, and more preferably not more than 5 minutes.
Setting the vacuum time in the above range results in a good solar cell module appearance following hot lamination, and is also desirable because the generation of air bubbles in the respective layers within the module can be suppressed.

The pressure applied during hot lamination is typically at least 50 kPa, preferably at least 70 kPa, and more preferably at least 90 kPa. On the other hand, this pressure is typically not more than 200 kPa, preferably not more than 150 kPa, and more preferably not more than 130 kPa. Setting the pressurizing conditions in the above range is preferable from the standpoint of durability because a suitable adhesion can be obtained without damaging the solar cell module.
The holding time at the above pressure is typically at least 1 minute, preferably at least 3 minutes, and more preferably at least 5 minutes. The upper limit is typically not more than 30 minutes, preferably not more than 20 minutes, and more preferably not more than 15 minutes. By setting the above holding time, a proper encapsulant gelling ratio can be achieved, thus enabling the power-generating properties to be fully exhibited and a sufficient adhesive strength to be obtained.

The temperature of hot lamination has a lower limit of typically at least 120°C, preferably at least 130°C, and more preferably at least 140°C. The upper limit is typically not more than 180°C, preferably not more than 160°C, and more preferably not more than 150°C. By setting the temperature in the above range, a sufficient adhesive strength can be obtained, and harmful effects such as melting of the PVC backing do not arise.
The heating time at the above temperature is typically at least 10 minutes, preferably at least 12 minutes, and more preferably at least 15 minutes. The upper limit is not more than 30 minutes, preferably not more than 20 minutes, and more preferably not more than 18 minutes. Setting the heating time in the above range is desirable because crosslinking of the encapsulant proceeds to a suitable degree, enhancing the durability and enabling the encapsulant to have a suitable degree of flexibility.

The solar cell module of the present invention may be suitably used as solar cells for building materials, solar cells for automobiles, solar cells for interior applications, solar cells for railroad applications, solar cells for ships, solar cells for airplanes, solar cells for spacecrafts, solar cells for home appliances, solar cells for cell phones and solar cells for toys. Preferred applications of the solar cell modules of the invention are solar cells for building materials used to construct exterior walls and roofs. Use as waterproof sheet-integrated solar cells having waterproof abilities as a roofing material is especially preferred.

The solar cell module of the present invention is described below in conjunction with the appended diagrams.

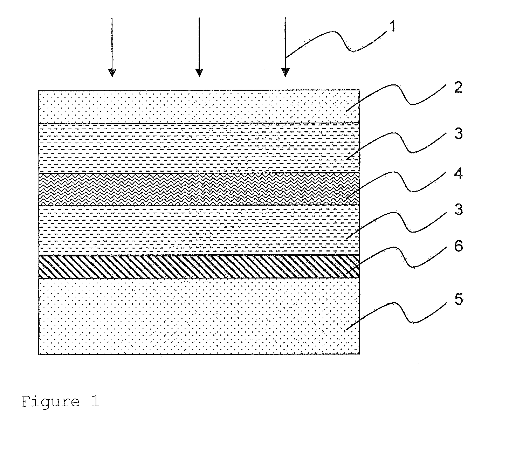

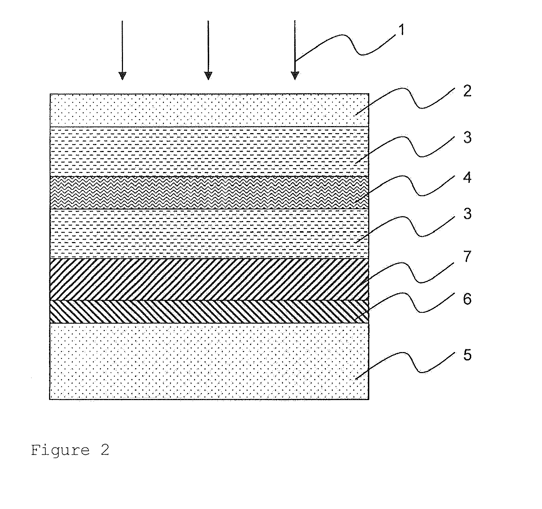

FIG. 1 is a schematic view of an embodiment of a solar cell module according to the present invention. The solar cell module of the present invention is formed of a PVC backing 5 on which are laminated in order: a first adhesive layer 6, a encapsulant 3-covered photoelectric conversion component 4, and a weather-resistant layer 2. By thus providing the first adhesive layer 6 between the PVC backing 5 and the encapsulant 3, migration of the plasticizer present in the PVC backing is prevented. Moreover, even when the module is exposed to an outdoor environment, a decline in the adhesive strength between the backing and the sealing layer does not arise, ensuring a sufficient adhesive strength. In a preferred embodiment, as shown in FIG. 2, a second adhesive layer 7 is provided between the first adhesive layer 6 and the encapsulant 3. By thus providing a second adhesive layer 7 between the first adhesive layer 6 and the encapsulant 3, the migration of plasticizer from the PVC backing 5 to the encapsulant can be completely prevented.

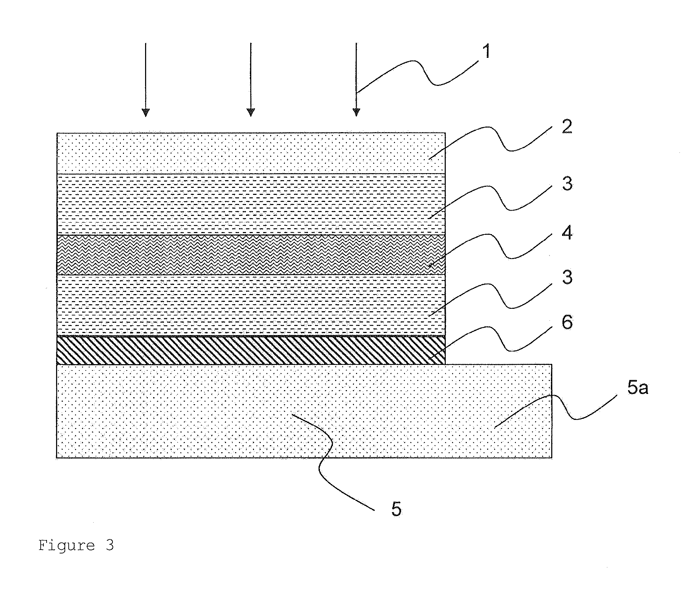

Moreover, as shown in FIG. 3, when the PVC backing 5 has a peripheral region 5a on which the photoelectric conversion component is not laminated, this has the advantage of enabling the solar cell module to be connected via this peripheral region to another solar cell module. Connection with another solar cell module may be achieved by thermal bonding.
In addition, layers not shown in FIGS. 1 to 3 may, of course, be suitably provided in accordance with the intended use.

### EXAMPLES

### Example 1

### (Fabrication of Peel Test Sample 1)

An ETFE film having a thickness of 100 µm (100HK-DCS, from Asahi Glass Co., Ltd.) as the weather-resistant film, an EVA film having a thickness of 300 µm (F806, from FIRST) as the encapsulant, an adhesive layer 1 (Axis Coat Primer for PVC (from Architectural Yamade Corporation): a mixture of a copolymer of hexamethylene diisocyanate and 1,4-butanediol, a copolymer of isophorone diisocyanate and 1,4-butanediol, and a copolymer of methyl methacrylate and propyl acrylate; thickness, 10 µm) as the first adhesive layer, and a polyester cloth-reinforced PVC sheet (containing 60 wt% of diisononyl phthalate (molecular weight, 419) as the plasticizer; measuring 20 cm square) as the PVC backing were stacked together and, using a vacuum laminator (from NPC), were hot laminated at 150°C (degree of vacuum, 80 Pa; vacuum time, 5 minutes; pressure, 101 kPa; pressurization time, 5 minutes; heating time, 15 minutes), thereby giving a Peel Test Sample 1.

### (Evaluation of Initial Adhesive Strength)

The resulting Peel Test Sample 1 was cut to a width of 25 mm, a T-peel test was carried out using a tensile tester (STA-1225, from ORIENTEC), and the adhesive strength at the interface between the encapsulant and the polyvinyl chloride was measured (JIS K 6854-3). The peel rate was set at 100 mm/min. The material broke, as a result of which it was not possible to measure the peel strength (adhesive strength: at least 80 N/25 mm).

### (Evaluation of Adhesive Strength Following High-Temperature Test)

A high-temperature test (85°C, 50% RH, 100 hours) was carried out on Peel Test Sample 1, following which the adhesive strength was measured. The adhesive strength was maintained at a high value (adhesive strength: 95 N/25 mm). The results are shown in Table 1. The above operations were repeated and high-temperature tests were continued for 1,000 hours, whereupon the adhesive strength maintained a high value.

### Example 2

### (Fabrication of Peel Test Sample 2)

Aside from using Adhesive Layer 2 (N-200NT (from 3M): a mixture of a copolymer of silane coupling agent-containing diphenylmethane diisocyanate and 1,4-butandiol with a copolymer of silane coupling agent-containing isophorone diisocyanate and 1,4-butanediol; thickness, 10 µm) as the first adhesive layer, the same operations were carried out as in Example 1, giving a Peel Test Sample 2.

### (Evaluation of Initial Adhesive Strength)

The adhesive strength was measured by carrying out the same operations as in Example 1, whereupon the material broke, making measurement impossible to carry out (adhesive strength: at least 80 N/25 mm). The results are shown in Table 1.

### (Evaluation of Adhesive Strength Following High-Temperature Test)

The adhesive strength following a high-temperature test was measured by carrying out the same operations as in Example 1, whereupon the adhesive strength maintained a high value (adhesive strength: 72 N/25 mm). The results are shown in Table 1. The above operations were repeated and high-temperature tests were continued for 1,000 hours, whereupon the adhesive strength maintained a high value.

### Example 3

### (Fabrication of Peel Test Sample 3)

Aside from using Adhesive Layer 3 (Toyo Primer PV (from Toyo): a mixture of methyl methacrylate and chloroprene rubber; thickness, 10 µm or less) as the first adhesive layer, the same operations were carried out as in Example 1, giving a Peel Test Sample 3.

### (Evaluation of Initial Adhesive Strength)

The adhesive strength was measured by carrying out the same operations as in Example 1, whereupon the material broke, making measurement impossible to carry out (adhesive strength: at least 80 N/25 mm). The results are shown in Table 1.

### (Evaluation of Adhesive Strength Following High-Temperature Test)

The adhesive strength following a high-temperature test was measured by carrying out the same operations as in Example 1, whereupon the adhesive strength maintained a high value (adhesive strength: 60 N/25 mm). The results are shown in Table 1. When the above operations were repeated and the high-temperature test was continued for 1,000 hours, the adhesive strength maintained a high value.

### Example 4

### (Fabrication of Peel Test Sample 4)

Aside from providing an ETFE film (100HK-DCS, from Asahi Glass Co., Ltd.; thickness, 100 µm; Adhesive Layer 1/second adhesive layer ratio, 0.1) between Adhesive Layer 1 and the encapsulant as the second adhesive layer, the same operations were carried out as in Example 1, giving a Peel Test Sample 4.

### (Evaluation of Initial Adhesive Strength)

The adhesive strength at the interface between the encapsulant and the PVC, as measured by carrying out the same operations as in Example 1, was 70 N/25 mm. The results are shown in Tables 1 and 2.

### (Evaluation of Adhesive Strength Following High-Temperature Test)

The interfacial adhesive strength following a high-temperature test was measured by carrying out the same operations as in Example 1, whereupon the adhesive strength maintained a high value (adhesive strength: 80 N/25 mm). The results are shown in Table 1.

### (Evaluation of Adhesive Strength Following High-Temperature, High-Humidity Test)

Sample 4 thus obtained was submitted to a high-temperature, high-humidity test (85°C, 85% RH, 200 hours), following which the adhesive strength was measured. The adhesive strength maintained a high value (adhesive strength: 72 N/25 mm). The results are shown in Table 2. When the above operations were repeated and the high-temperature, high-humidity test was continued for 800 hours, the adhesive strength maintained a high value.

### Example 5

### (Fabrication of Peel Test Sample 5)

Aside from setting the thickness of the ETFE film serving as the second adhesive layer between Adhesive Layer 1 and the encapsulant to 50 µm (Adhesive Layer 1/second adhesive layer ratio, 0.2), the same operations were carried out as in Example 4, giving a Peel Test Sample 5.

### (Evaluation of Initial Adhesive Strength)

The adhesive strength at the interface, as measured by carrying out the same operations as in Example 1, was 53 N/25 mm. The results are shown in Table 2.

### (Evaluation of Adhesive Strength Following High-Temperature, High-Humidity Test)

The interfacial adhesive strength following a high-temperature, high-humidity test was measured by carrying out the same operations as in Example 4, whereupon the adhesive strength substantially maintained the initial value (adhesive strength: 40 N/25 mm). The results are shown in Table 2. When the above operations were repeated and the high-temperature, high-humidity test was continued for 400 hours, the adhesive strength maintained a high value.

### Example 6

### (Fabrication of Peel Test Sample 6)

Aside from setting the thickness of the ETFE film serving as the second adhesive layer between Adhesive Layer 1 and the encapsulant to 25 µm (Adhesive Layer 1/second adhesive layer ratio, 0.4), the same operations were carried out as in Example 4, giving a Peel Test Sample 6.

### (Evaluation of Initial Adhesive Strength)

The adhesive strength at the interface, as measured by carrying out the same operations as in Example 1, was 40 N/25 mm. The results are shown in Table 2.

### (Evaluation of Adhesive Strength Following High-Temperature, High-Humidity Test)

The interfacial adhesive strength following a high-temperature, high-humidity test was measured by carrying out the same operations as in Example 4, whereupon the adhesive strength maintained the initial value (adhesive strength: 46 N/25 mm). The results are shown in Table 2. When the above operations were repeated and the high-temperature, high-humidity test was continued for 400 hours, the adhesive strength maintained a high value.

### Example 7

An ETFE film having a thickness of 100 µm (100HK-DCS, from Asahi Glass Co., Ltd.) was used as the weather-resistant layer. Using polyethylene naphthalate (PEN) as the photoelectric conversion device base material, an amorphous silicon solar cell was provided on the PEN, and both the PEN and the solar cell sides were covered with EVA films having a thickness of 300 µm (F806, from FIRST) to form a photoelectric conversion component. Using an ETFE film (100HK-DCS, from Asahi Glass Co., Ltd.; thickness, 100 µm; Adhesive Layer 1/second adhesive layer ratio, 0.1) as the second adhesive layer, a polyester cloth-reinforced PVC sheet (containing 60% of diisononyl phthalate (molecular weight, 419) as the plasticizer; 20 cm square) provided on the adhesive side of Adhesive Layer 1 in the same way as in Example 1 was placed thereon and, using a vacuum laminator (from NPC), hot lamination was carried out at 150°C (degree of vacuum, 80 Pa; vacuum time, 5 minutes; pressure, 101 kPa; pressurization time, 5 minutes; heating time, 15 minutes), thereby giving a PVC sheet-integrated solar cell module.

### (High-Temperature, High-Humidity Test)

The resulting PVC sheet-integrated solar cell module was subjected to a high-temperature, high-humidity test (85°C, 85% RH, 100 hours), following which the electrical properties were investigated and found to be good: 0% change in short-circuit current, 3% change in open-circuit voltage, and 2% change in fill factor. The results are shown in Table 3.

### (Ultra-Accelerated Weathering Test)

The electrical properties after subjecting the PVC sheet-integrated solar cell module obtained to an ultra-accelerated weathering test (360 hours of irradiation with a metal halide lamp, 63°C, 50% RH, 2-minute shower every 2 hours, lamp illumination: 75 mW/cm² (330 to 390 nm)), were investigated and found to be good: 8% change in short-circuit current, 1% change in open-circuit voltage, and 5% change in fill factor. The results are shown in Table 3.

From the above results, with regard also to the long-term durability, the module maintained a good adhesion as a laminate and good electrical properties as a solar cell.

### Comparative Example 1

### (Fabrication of Peel Test Sample 7)

Aside from not providing Adhesive Layer 1, the same operations were carried out as in Example 1, giving Peel Test Sample 7.

### (Evaluation of Initial Adhesive Strength)

The adhesive strength at the encapsulant/PVC backing interface, as measured by carrying out the same operations as in Example 1, was 62 N/25 mm. The results are shown in Table 1.

### (Evaluation of Adhesive Strength Following High-Temperature Test)

The adhesive strength at the encapsulant/PVC backing interface following a high-temperature test was measured by carrying out the same operations as in Example 1, whereupon the adhesive strength underwent a large decrease (adhesive strength: 35 N/25 mm). The results are shown in Table 1. When the above operations were repeated and the high-temperature test was continued for 1,000 hours, the adhesive strength gradually declined.

### (Evaluation of Adhesive Strength Following High-Temperature, High-Humidity Test)

The adhesive strength at the encapsulant/PVC backing interface following a high-temperature, high-humidity test was measured by carrying out the same operations as in Example 4, whereupon the adhesive strength underwent a larger decrease than in the high-temperature test (adhesive strength: 27 N/25 mm). The results are shown in Table 2.

### Comparative Example 2

### (Fabrication of Peel Test Sample 8)

Aside from not using an acrylic resin as Adhesive Layer 1, the same operations were carried out as in Example 1, giving Peel Test Sample 8.

### (Evaluation of Initial Adhesive Strength)

The adhesive strength at the encapsulant/PVC backing interface was measured by carrying out the same operations as in Example 1. The results are shown in Table 2.

### (Evaluation of Adhesive Strength Following High-Temperature, High-Humidity Test)

The adhesive strength at the encapsulant/PVC backing interface following a high-temperature, high-humidity test was measured by carrying out the same operations as in Example 4. The results are shown in Table 2.

### Comparative Example 3

### (Fabrication of Peel Test Sample 9)

Aside from using a modified acrylic resin as Adhesive Layer 1, the same operations were carried out as in Example 1, giving Peel Test Sample 9.

### (Evaluation of Initial Adhesive Strength)

The adhesive strength at the encapsulant/PVC backing interface was measured by carrying out the same operations as in Example 1. The results are shown in Table 2.

### (Evaluation of Adhesive Strength Following High-Temperature, High-Humidity Test)

The adhesive strength at the encapsulant/PVC backing interface following a high-temperature, high-humidity test was measured by carrying out the same operations as in Example 4. The results are shown in Table 2.

**Table 1: Adhesive strength before and after high-temperature test (85°C, 50% RH, 100 hrs)**

| | PVC backing | First adhesive layer | | Second adhesive layer | | Peel strength (N/25 mm) | |
|---|---|---|---|---|---|---|---|
| | Amount of plasticizer (%) | Type | Thickness (µm) | Type | Thickness (µm) | Initial value | After high-temperature test |
| Example 1 | 60 | 2 types of urethane resin, 1 type of (meth)acrylic resin | 10 | - | - | Material broke | 95 |
| Example 2 | 60 | 2 types of silane coupling agent-containing urethane resin | 10 | - | - | Material broke | 72 |
| Example 3 | 60 | 1 type of methacrylic resin, 1 type of chloroprene rubber | 10 | - | - | Material broke | 60 |
| Example 4 | 60 | 2 types of urethane resin, 1 type of (meth)acrylic resin | 10 | ETFT | 100 | 70 | 80 |
| Comparative Example 1 | 60 | - | - | - | - | 62 | 35 |

**Table 2: Adhesive strength before and after high-temperature, high-humidity test (85°C, 85% RH, 200 hrs)**

| | PVC backing | First adhesive layer | | Second adhesive layer | | Peel strength (N/25 mm) | |
|---|---|---|---|---|---|---|---|
| | Amount of plasticizer (%) | Type | Thickness (µm) | Type | Thickness (µm) | Initial value | After high-temperature test |
| Example 4 | 60 | 2 types of urethane resin, 1 type of (meth)acrylic resin | 10 | ETFT | 100 | 70 | 72 |
| Example 5 | 60 | 2 types of urethane resin, 1 type of (meth)acrylic resin | 10 | ETFT | 50 | 53 | 40 |
| Example 6 | 60 | 2 types of urethane resin, 1 type of (meth)acrylic resin | 10 | ETFT | 25 | 40 | 46 |
| Comparative Example 1 | 60 | - | - | - | - | 62 | 27 |
| Comparative Example 2 | 60 | 1 type of acrylic resin | 10 | - | - | 3 | 2 |
| Comparative Example 3 | 60 | 1 type of modified acrylic resin | 10 | - | - | Material broke | 25 |

**Table 3: Electrical properties of PVC sheet-integrated solar cell module**

| | Short-circuit current (A) (amount of change from initial value) | Open-circuit voltage (V) (amount of change from initial value) | Fill factor (%) (amount of change from initial value) |
|---|---|---|---|
| After high-temperature, high-humidity test | 0.153 (0%) | 7.373 (+3%) | 0.572 (-2%) |
| Before high-temperature, high-humidity test | 0.153 | 7.133 | 0.582 |
| After ultra-accelerated weathering test | 0.140 (-8%) | 7.014 (-1%) | 0.491 (+5%) |
| Before ultra-accelerated weathering test | 0.153 | 7.084 | 0.470 |

While the invention has been described in detail and with reference to specific embodiments thereof, it will be apparent to one skilled in the art that various changes and modifications can be made therein without departing from the spirit and scope thereof.

### EXPLANATION OF REFERENCE NUMERALS

- 1: Sunlight
- 2: Weather-resistant layer
- 3: Encapsulant
- 4: Photoelectric conversion component (photoelectric conversion device and photoelectric conversion device base material)
- 5: PVC sheet
- 5a: Peripheral area
- 6: First adhesive layer
- 7: Second adhesive layer

## Claims

1. A solar cell module comprising a polyvinyl chloride backing, and a encapsulant-covered photoelectric conversion component and a weather-resistant layer that are laminated in this order on the backing,
wherein the module has a first adhesive layer between the polyvinyl chloride backing and the encapsulant-covered photoelectric conversion component, the first adhesive layer being formed of a single layer and containing a plurality of resins.

2. The solar cell module according to claim 1, wherein the first adhesive layer has a film thickness of 80 µm or less.

3. The solar cell module according to claim 1 or 2,
wherein the polyvinyl chloride backing is a plasticized polyvinyl chloride backing.

4. The solar cell module according to any one of claims 1 to 3, wherein the first adhesive layer includes at least one material selected from the group consisting of urethane resins, acrylic resins, methacrylic resins, epoxy resins and chloroprene rubbers.

5. The solar cell module according to any one of claims 1 to 4, further comprising a second adhesive layer between the first adhesive layer and the encapsulant-covered photoelectric conversion component.

6. The solar cell module according to claim 5, wherein the second adhesive layer has a film thickness which is larger than the film thickness of the first adhesive layer.

7. The solar cell module according to any one of claims 1 to 6, wherein the polyvinyl chloride backing contains a reinforcement.

8. The solar cell module according to any one of claims 1 to 7, wherein the polyvinyl chloride backing has a peripheral region on which the encapsulant-covered photoelectric conversion component and the weather-resistant layer are not laminated, and the solar cell module is connectable to another solar cell module via the peripheral region.

9. A building material comprising the solar cell module according to any one of claims 1 to 8.
